# EUROPEAN PATENT SPECIFICATION

(11) **EP 4 436 046 B1**
(45) Date of publication and mention of the grant of the patent: **28.10.2026**
(21) Application number: 24165323.7
(22) Date of filing: 21.03.2024
(51) Int. Cl.: H03L 1/02, H03L 7/099

(54) **METHODS AND SYSTEMS FOR REDUCING A FREQUENCY DRIFT IN A VOLTAGE CONTROLLED OSCILLATOR (VCO)**
VERFAHREN UND SYSTEME ZUR VERRINGERUNG EINER FREQUENZDRIFT IN EINEM SPANNUNGSGESTEUERTEN OSZILLATOR (VCO)
PROCÉDÉS ET SYSTÈMES POUR RÉDUIRE UNE DÉRIVE DE FRÉQUENCE DANS UN OSCILLATEUR COMMANDÉ EN TENSION (VCO)

(30) Priority: 24.03.2023 IN 202341021244; 12.07.2023 IN 202341021244
(43) Date of publication of application: 25.09.2024
(73) Proprietor: Samsung Electronics Co., Ltd., Suwon-si, Gyeonggi-do 16677 (KR)
(72) Inventor: SIDDAMURTHY, Subba Reddy, 560048 Bengaluru (IN); TADINADA, Aswani Aditya Kumar, 560048 Bengaluru (IN); ISSA, Venkatasuryam Setty, 560048 Bengaluru (IN)
(74) Representative: Marks & Clerk LLP

(56) References cited:
- US-A1- 2005 128 017
- US-A1- 2007 159 264
- SOULIOTIS GEORGE ET AL: "Temperature compensated ring oscillator based VCO", AEU - INTERNATIONAL JOURNAL OF ELECTRONICS AND COMMUNICATIONS, ELSEVIER, AMSTERDAM, NL, vol. 149, 28 March 2022 (2022-03-28), XP087015681, ISSN: 1434-8411, [retrieved on 20220328], DOI: 10.1016/J.AEUE.2022.154195

## Description

### TECHNICAL FIELD

Embodiments disclosed herein relate to reducing a frequency drift in a voltage to current converter (V2I) based VCO by introducing a conversely proportional to absolute temperature (CTAT) response in a V2I output current to a ring oscillator (RO).

### BACKGROUND

Wireless communication devices may be configured to operate in an assigned frequency band within an allocated spectrum of available frequency bands. The allocated spectrum may be a contiguous frequency span or may comprise multiple disjoint frequency spans. The frequency assignment may be dynamic and may change during the course of communications.

Wireless communication devices may incorporate a Voltage Controlled Oscillator (VCO) that may be tuned across a tuning range that enables the device to operate in any assigned frequency band from the multiple frequency bands. A VCO may generate an oscillating signal with a frequency that is dependent on an input voltage. The VCO may be incorporated into a frequency synthesizer that may include a phase locked loop (PLL) that is configured to maintain a control voltage of the VCO at a value that tunes the VCO output frequency to a desired frequency.

As the frequency response of the VCO varies over an operating temperature range, the PLL provides different control voltage values over various temperatures to achieve the desired VCO frequency. The change in a free running VCO output frequency for a provided voltage value may be referred to a temperature drift. A large VCO temperature drift may increase the range of control voltage used to maintain the desired VCO output frequency over a temperature range.

Wide band PLLs suffer from frequency drift issues with changes in temperature. Typically, frequency drift issues may be solved using part of current for a Ring oscillator (RO) from temperature compensation circuits (such as proportional to absolute temperature (PTAT)/CTAT). However, this may not be suitable for wide band PLLs. Also, absolute VCO frequency drift may be constant across all the frequencies of operation. Because of this, at the lower side of VCO frequency band, frequency correction range with control voltage may be limited compared to the higher side of the bands due to low signal gain (K_{vco}). Therefore, to correct VCO frequency drift at lower frequency bands, the frequency drift has been reduced with temperature compensation and the signal gain has been increased.

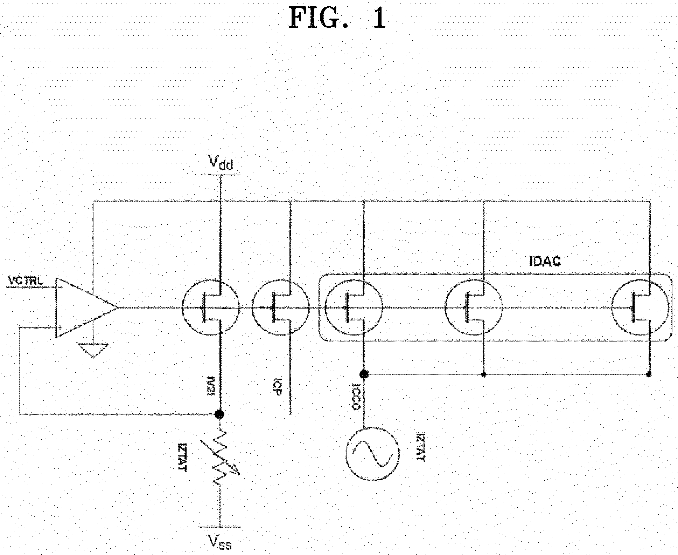

FIG. 1 depicts an example scenario, wherein the resistor-based voltage to current converter (V2I) controls current, ICCO, of a current controlled ring oscillator (CCO). As illustrated, IV2I = Vctrl/R, ICCO=IV2I*K_{IDAC}, wherein K_{IDAC} is a V2I IDAC (current of a digital to analog converter) gain. VCO small signal gain, K_{VCO} = K_{ICCO}*K_{IDAC}/R, wherein K_{ICCO} is current controlled oscillator (CCO) gain. K_{ICCO} = 2π(Δf_{VCO}/ΔI_{CCO}). The Δf_{VCO} may represent a change in oscillation frequency of the VCO and ΔI_{CCO} may represent a change in input current to the CCO. Accordingly, K_{ICCO} represents the change in the frequency of the signal output by the CCO relative to a change in input current. As illustrated in FIG. 1, the resistor may have a negligible temperature co-efficient, therefore ICCO may have an approximate negligible temperature co-efficient. Therefore, the voltage to frequency gain K_{VCO} of the VCO should be high enough to correct the drift in frequency of the oscillator with temperature. Conventional PLL systems are known from SOULIOTIS GEORGE ET AL: "Temperature compensated ring oscillator based VCO", AEU - INTERNATIONAL JOURNAL OF ELECTRONICS AND COMMUNICATIONS, ELSEVIER, AMSTERDAM, NL, vol. 149, 28 March 2022, ISSN: 1434-8411, DOI: 10.1016/J.AEUE.2022.154195, US 2005/128017 A1 and US 2007/159264 A1.

Hence, at lower technology nodes, the available range of V control voltage (Vctrl) may be reduced due to supply scaling.

### SUMMARY

The above problems are solved by the circuits of claims 1-3 or by the method of claim 4.

In embodiments, a temperature coefficient for the ICCO current is induced in an opposite direction to the temperature coefficient of the CCO. Accordingly, temperature induced frequency shift can be prevented or reduced even when the input voltage Vctrl reaches an undesirable range (a range where it is difficult for changes in Vctrl to compensate for frequency variations). Embodiments disclose methods and systems for reducing a temperature-induced frequency drift in a voltage to current converter (V2I) based voltage-controlled oscillator (VCO) unit.

Embodiments disclose methods and systems for introducing temperature behavior in output current of V2I architecture with output current connected to a ring oscillator (RO).

Embodiments disclose methods and systems for correcting the temperature-induced frequency drift of the RO by extending the fine tune frequency correction range.

The features of the invention are set out in the claims.

These and other aspects of embodiments herein will be better appreciated and understood when considered in conjunction with the following description and the accompanying drawings. It should be understood, however, that the following descriptions, while indicating embodiments and numerous specific details thereof, are given by way of illustration and not of limitation. Many changes and modifications may be made within the scope of embodiments herein without departing from the scope of the invention, and embodiments herein include all such modifications.

### BRIEF DESCRIPTION OF FIGURES

Embodiments disclosed herein are illustrated in the accompanying drawings, throughout which like reference letters indicate corresponding parts in the various figures. Embodiments herein will be better understood from the following description with reference to the drawings, in which:
FIG.1 depicts an example scenario, wherein the resistor-based voltage to current converter controls current, ICCO, of current controlled ring oscillator (CCO), according to the prior art;
FIG. 2 depicts an example diagram of a circuit to reduce a frequency drift in a voltage to current converter (V2I) based VCO by introducing a temperature behavior in CCO current, according to embodiments as disclosed herein;
FIG. 3 depicts an example block diagram of a system to reduce the frequency drift in the V2I based VCO architecture, according to embodiments as disclosed herein; and
FIG. 4 is a flow diagram depicting a method for reducing a frequency drift with temperature in a voltage to current converter (V2I) based VCO architecture for at least one wide band phase-locked loop (PLL), according to embodiments as disclosed herein.

### DETAILED DESCRIPTION

Embodiments herein and the various features and advantageous details thereof are explained more fully with reference to the non-limiting examples that are illustrated in the accompanying drawings and detailed in the following description. Descriptions of well-known components and processing techniques are omitted so as to not unnecessarily obscure embodiments herein. The examples used herein are intended merely to facilitate an understanding of ways in which embodiments herein may be practiced and to further enable those of skill in the art to practice embodiments herein. Accordingly, the examples should not be construed as limiting the scope of embodiments herein.

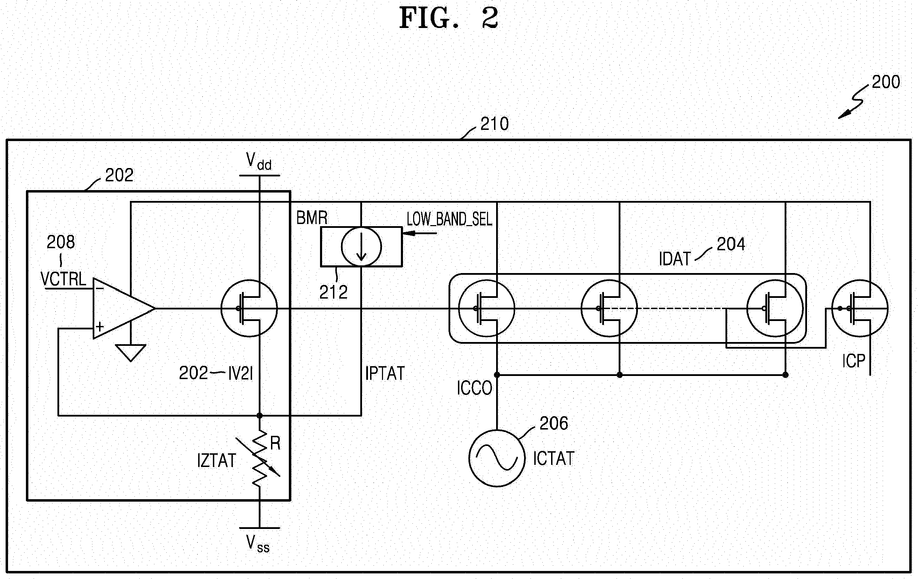

Embodiments herein provide a circuit 200 for reducing a temperature-induced frequency drift in a voltage to current converter (V2I) based VCO architecture for at least one wide band phase-locked loop (PLL). The circuit may be configured to provide a fixed offset current to the resistor node of the V2I circuit, wherein CTAT behavior may be introduced on the V2I output current. According to embodiments, the introduction of CTAT behavior may include causing the V2I output current to have a value conversely proportional to a temperature of the circuit 200. As discussed herein, conversely proportional may be also referred to as "inversely proportional". Further, the V2I output current may be mirrored to a current controlled oscillator unit (CCO) to reduce the frequency drift at lower bands of the oscillator frequency. Referring now to the drawings, and more particularly to FIGS. 2 through 4, where similar reference characters denote corresponding features consistently throughout the figures, there are shown at least one example.

Embodiments herein disclose the circuit 200, wherein the circuit may force a fixed offset PTAT current to the resistor node of V2I architecture to provide CTAT behavior to the at least one V2I output current. According to embodiments, the fixed offset PTAT current may have a value proportional to the temperature of the circuit 200. Further, embodiments disclose selectively tuning a PTAT branch at the lower band of oscillator frequency without affecting loop dynamics of the wide band PLL and forcing fixed PTAT current to the resistor node to extend the fine tune frequency correction range of the VCO. Selectively turning on the PTAT branch may be performed only at a lower band of PLL operation where fine tune correction of VCO is limited due to low signal gain.

FIG. 2 depicts an example diagram of a circuit to reduce a frequency drift in a voltage to current converter (V2I) based VCO by introducing a temperature behavior in CCO current, according to embodiments as disclosed herein.

As depicted in FIG. 2, the circuit 200 comprises a VCO 210 that is formed from a V2I 202 that outputs a current to a CCO 206. The V2I 202 takes an input voltage Vctrl and outputs a current. In the present embodiment, the output of the V2I 202 is mirrored in a digital to analog converter or current mirror IDAC 204. The current output from the IDAC 204 is then fed into the CCO 206.

As depicted in FIG. 2, the circuit 200 may be configured with a voltage control pin (Vctrl) (input) connected to the voltage to current converter (V2I) 202, and the current controlled oscillator (CCO) 206 (also referred to herein as the CCO circuit 206 or the CCO configuration 206) is connected to the IDAC 204 (also referred to herein as the IDAC configuration 204). As depicted, VCO 210 (also referred to herein as the VCO architecture 210) is an electronic oscillator with the oscillation frequency controlled by the Vctrl 208 (e.g., an operational amplifier). The instantaneous oscillation frequency of the VCO 210 may depend on an applied input voltage. The VCO 210 may be used for frequency modulation (FM) or phase modulation (PM) by applying a modulating signal to the control input. Hence, the VCO 210 forms an integral part of phase locked loop (PLL) signal.

As depicted, the V2I converter 202 of the electronic circuit 200 may produce current as the output for the applied voltage. V2I may be used to create a current which is corresponding or proportional to the definite voltage (the applied voltage), which may change the carrier of electrical data from voltage to current.

In the present embodiment the V2I 202 comprises an amplifier (an operational amplifier, op-amp), a transistor (e.g. a P-type metal-oxide-semiconductor (PMOS) transistor) and a resistor. The amplifier receives an input voltage VCTRL (otherwise known as a control voltage) at a first input terminal (e.g. an inverting input terminal). An output of the amplifier is connected to a gate of the transistor. One terminal (e.g. the drain) of the transistor is connected to a voltage V_{DD} (e.g. a first power supply voltage). Another terminal (e.g. a source) of the transistor is connected to a resistor node. The resistor node is connected to a first end of the resistor. A second end of the resistor is connected to another voltage V_{SS} (e.g. a second power supply voltage, such as ground - the second power supply voltage may be less than the first power supply voltage).

Negative feedback is provided to the amplifier by connecting a second input terminal of the amplifier (e.g. a non-inverting input terminal) to the resistor node. Through this arrangement, the V2I 202 is configured to provide convert the input voltage VCTRL into a current. The output current of the V2I 202 is proportional to the input voltage VCTRL. The negative feedback loop may control the amplifier to ensure that the amplifier maintains a specific current (based on the input voltage) through the resistor.

Hence, on supplying voltage as input to a circuit which comprises a resistor, a proportional current may commence to flow through it. The value of a resistor may decide the current flow in the circuit to perform a simple voltage to current conversion for a linear circuit.

The phase locked loop (PLL) is the circuit where the voltage or voltage driven oscillator may be constantly adjusted to match the frequency of the input signal which may generate multiple frequencies. Phase differences generated in the PLL may be constant with the generated frequency. Frequency drift may occur in the circuit which results in unintended and arbitrary offset of the oscillator from its nominal frequency, causing illegal or unwanted interferences in the adjacent channels. It may occur due to change in temperature or due to change in the bias current provided to the oscillator.

To overcome the above issue, the frequency drift with change in temperature of the V2I convertor 202 (also referred to herein as the V2I 202) based on VCO architecture 210 may be reduced based on the configured circuit 200. The circuit may be configured to apply a fixed offset current to the V2I resistor node, at a lower frequency of the circuit, wherein the CTAT behavior may be introduced to the V2I output. As described herein, a lower frequency may be a frequency below a threshold frequency or may be a particular frequency range. The circuit may be configured to provide the fixed offset current in response to determining that the frequency of the circuit is below the threshold frequency, or falls within a particular frequency range. Further, the fixed offset current may include, but not limited to, PTAT, CTAT and constant with absolute temperature (ZTAT) behavior based on the type of temperature-induced frequency behavior of the VCO. The circuit 200 may be configured to mirror the generated V2I output current with the CTAT behavior into CCO to reduce the frequency drift. Mirroring may be performed using IDAC configuration 204 to the CCO 206 of the circuit to reduce the frequency drift at the lower band of the oscillator frequency. The IDAC configuration 204 may be configured to mirror the V2I output current to CCO. Whilst the IDAC 204 is referred to as a digital to analog converter, it may equally be referred to as a current mirror. Also, the fixed offset PTAT current (IPTAT) forced into the V2I resistor node may extend a fine tune frequency correction range of the VCO.

According to an embodiment, the IDAC 204 may comprise one or more transistors (e.g. PMOS transistors). A gate of each of the transistors of the IDAC 204 may be connected to the gate of the PMOS transistor of the V2I 202. A first terminal (e.g. a drain) of the PMOS transistors of the IDAC 204 may be connected to the first terminal of the PMOS transistor of the V2I 202. A second terminal (e.g. a source) of each of the transistors of the IDAC204 may be connected to an output node. The output node may be connected to the CCO 206. The IDAC 204 may be configured to mirror the current IV2I passing through the transistor of the V2I 202 to produce ICCO which is input into the CCO 206. The current ICCO output by the IDAC 204 may be proportional to, or equal to, the current IV2I passing through the transistor of the V2I 202. t

In embodiments, the fixed offset PTAT current may be forced (e.g., applied) into the V2I resistor node of the circuit 200. The negative feedback of the V2I amplifier (e.g., the Vctrl 208 included in the V2I converter) may maintain the current (e.g., the resistor current) through the resistor at the end of the V2I resistor node, which is proportional to Vctrl/R. That is, due to the negative feedback loop implemented with the amplifier, any increase in current caused by the fixed offset PTAT current may result in a reduction in the current IV2I passing through the transistor of the V2I 202. This therefore maintains a constant current through the resistor. Further, as the "R" resistor has a negligible temperature co-efficient, the current (e.g., the resistor current) through the resistor (e.g., with negative feedback) may be always in ZTAT nature (IZTAT).

In one embodiment, the fixed offset current is provided by current reference circuit, such as a beta-multiplier reference (BMR) 212. The current reference circuit can generate an offset current (otherwise known as a reference current), for instance, across a resistor that receives a base-emitter voltage of a bipolar transistor, the different between the base-emitter voltages of two transistors. That is, a reference current can be generated based on a reference voltage based on the particular characteristics of one or more transistors.

The current reference circuit may be configured to output the fixed offset current with a particular temperature response. This temperature response (e.g. PTAT, CTAT or ZTAT) can be set based on the arrangement and characteristics, such as the temperature coefficients, of components of the current reference circuit (e.g. one or more transistors and/or one or more resistors).

For the remainder of the description, the current reference circuit will be described as a beta-multiplier reference 212; however, it will be appreciated that other forms of current reference circuit may be provided.

The beta-multiplier reference 212 may be configured to generate the offset current in response to an activation a low frequency band selection signal (LOW_BAND_SEL). The low frequency band selection signal LOW_BAND_SEL may be activated when the frequency is below a threshold. The low frequency band selection signal may activate the BMR 212 to control the BMR 212 to provide the fixed offset current.

By Kirchoff's current law (KCL), current through the resistor is the sum of offset current PTAT from the beta-multiplier reference (BMR) 212 and the current passing through the V2I transistor. In the present embodiment, the V2I transistor is a PMOS transistor. When activating the PMOS transistor, by lowering the voltage on the gate, the resulting circuit may be configured to allow the conduction of electron holes between the source and drain, turning (e.g., switching) the circuit "ON". The BMR 212 is a current reference, formed by NMOS and PMOS current mirroring. The negative feedback to the amplifier ensures that the resistor current is always ZTAT (temperature invariant). As the offset current is PTAT, the negative feedback causes the V2I PMOS branch current to exhibit CTAT behavior to compensate. That is, the V2I PMOS branch current may be of CTAT nature, which may cancel out the PTAT behavior of the offset current provided by the BMR 212. According to embodiments, the voltage on the gate of the PMOS may be lowered in response to a control signal from a controller (e.g. Vctrl, or the LOW_BAND_SEL signal that activates the BMR 212). According to embodiments, the controller may output the control signal in response to determining that the desired frequency (e.g., at which the VCO is configured to oscillate) falls within the lower frequency band of the VCO (e.g., based on a sensed frequency, input indicating the desired frequency, etc.). The lower frequency band may be a frequency band that is lower than a higher frequency band, over which the control signal is not output. According to embodiments, the fixed offset current may be configured to have a value that is PTAT by increasing a voltage to frequency gain (K_{VCO}) of the VCO. According to embodiments, the fixed offset current is configured to have a value that is PTAT and induces an opposite frequency drift (e.g. a CTAT response) in a current provided to the CCO.

Further, in embodiments, the circuit 200 may be configured to reduce the temperature-induced frequency drift in the VCO architecture (V2I and CCO) 210 of the wide band PLL signal. The circuit 200 may be configured by applying a fixed offset current in the V2I resistor node at a lower frequency to introduce CTAT behavior in the V2I output (e.g., to cause the V2I converter output current to have a value that is CTAT). Further, the V2I output current with the CTAT nature may be mirrored into the CCO circuit 206 to reduce the frequency drift, forcing the fixed offset PTAT current into the V2I resistor node may extend the fine tune frequency correction range of VCO 210. According to embodiments, the fixed offset current may be generated based on a control signal from the controller (e.g. LOW_BAND_SEL). According to embodiments, the control signal may be based on a determined characteristic (e.g., magnitude, etc.) of temperature-induced frequency drift in the VCO 210 (e.g., determined based on a temperature sensed by a temperature sensor, received in an input signal, etc.)). According to embodiments, the control signal may be determined such that the resulting fixed offset current will cause the V2I converter output current to be CTAT and correct for the frequency drift in the VCO 210.

In embodiments, the circuit 200 may be configured to reduce the frequency drift with temperature in the VCO architecture (V2I and CCO) 210 of the wide band PLL signal. The circuit 200 may be configured by applying the fixed offset current in the V2I resistor node at a lower frequency to introduce CTAT behavior in the V2I output current. That is, the circuit 200 may be configured to determine when the frequency is below a particular threshold (e.g. falls within a low frequency range) and, in response to determining that the frequency is below the threshold, apply the fixed offset current.

The fixed offset current may be, but not limited to, PTAT, CTAT, ZTAT and the like, based on the type of frequency behavior with temperature of the VCO 210. When the temperature behavior of the VCO is CTAT, the fixed offset current may be CTAT to induce PTAT behavior in the ICCO current (to compensate for the CTAT behavior of the VCO). When the temperature behavior of the VCO is PTAT, the fixed offset current may be PTAT to induce CTAT behavior in the ICCO current (to compensate for the PTAT behavior of the VCO). Mirroring of V2I output current with CTAT behavior may be performed to reduce the frequency drift. Fixed offset PTAT current may be forced into the V2I resistor node to extend the fine frequency correction range of the VCO. Therefore, selectively tuning the PTAT branch at a lower frequency band may reduce the frequency drift with temperature without affecting loop dynamics in the wide band PLL signals. Selective turning on the PTAT branch may be performed only at a lower band of PLL operation where fine tune correction of VCO is limited due to low signal gain.

According to embodiments, the output signal of the CCO 206 in which the temperature-induced frequency drift has been removed and/or reduced may be used to generate a CCO output signal of a desired frequency. According to embodiments, the CCO output signal may be combined with data (e.g., application data in a baseband signal) to generate an outgoing communication signal for transmission (e.g., a radio frequency (RF) signal). According to embodiments, the CCO output signal may be combined with data (e.g., application data in an RF signal) to generate a received communication signal (e.g., a baseband signal) to be provided to a processor.

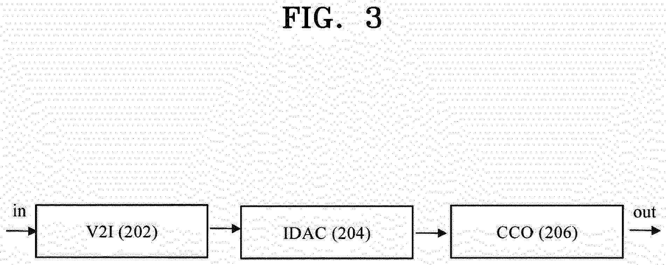

FIG. 3 depicts an example block diagram of a system to reduce the frequency drift in the V2I based VCO architecture, according to embodiments as disclosed herein. The system may include the V2I converter 202, the IDAC 204 and/or the CCO 206 discussed above in connection with FIG. 2.

As depicted in the diagram, the circuit 200 may be configured to force (e.g., apply) a fixed offset current to the resistor node of V2I converter 202, wherein CTAT behavior may be introduced to the V2I output current. The V2I 202 and the CCO 206 may be combined to form the VCO architecture 210. Further, the V2I output current may be provided to the IDAC 204, which may mirror the V2I output current to be provided to the CCO 206 to reduce the frequency drift at the lower band of the oscillator frequency.

Further, embodiments disclose selectively turning on the PTAT branch at the lower band of oscillator frequency without affecting loop dynamics of the wide band PLL and forcing the fixed PTAT current to the resistor node to extend the fine tune frequency correction range of the VCO 210. Selective turning on the PTAT branch may be performed only at the lower band of PLL operation where fine tune correction of VCO is limited due to low signal gain.

Further, the frequency drift with change in temperature of the V2I 202 convertor based on the VCO 210 may be reduced based on the configured circuit. The circuit may be configured to apply a fixed offset current to the V2I resistor node, at the lower frequency of the circuit, wherein the CTAT behavior may be introduced to the V2I output. Further, the fixed offset current may include, but not limited to, PTAT, CTAT and/or ZTAT based on the type of VCO frequency behavior with temperature. The circuit 200 may be configured to mirror the generated V2I output current with the CTAT behavior into the CCO to reduce the frequency drift.

Mirroring may be performed using the IDAC configuration 204 to the CCO 206 of the circuit 200 to reduce the frequency drift at the lower band of the oscillator frequency. The IDAC configuration 204 may be configured to mirror the V2I output current of the circuit to the CCO configuration 206. Also, the fixed offset PTAT current forced into the V2I resistor node may extend the fine tune frequency correction range of the VCO 210.

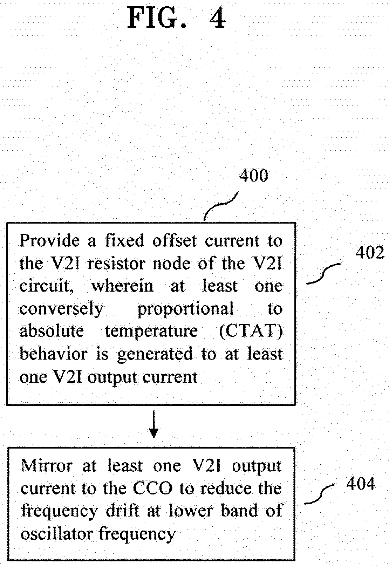

FIG. 4 is a flow diagram depicting a method for reducing a frequency drift with temperature in a voltage to current converter (V2I) based VCO architecture for at least one wide band phase-locked loop (PLL), according to embodiments as disclosed herein. According to embodiments, the method may be implemented using the circuit 200 discussed in connection with FIG. 2, and/or the system discussed in connection with FIG. 3. Operation 402 includes providing a fixed offset current to the V2I resistor node of the V2I circuit, wherein at least one conversely proportional to absolute temperature (CTAT) behavior is generated to at least one V2I output current. Operation 404 includes mirroring at least one V2I output current to the CCO to reduce the frequency drift at a lower band of oscillator frequency. The various actions, acts, blocks, operations, or the like in the method and the flow diagram 400 may be performed in the order presented, in a different order, simultaneously or contemporaneously. Further, in embodiments, some of the actions, acts, blocks, operations, or the like may be omitted, added, modified, skipped, or the like without departing from the scope of the invention as defined by the appended claims.

Embodiments disclosed herein may be implemented through at least one software program running on at least one hardware device and performing network management functions to control the elements. The elements may be at least one of a hardware device, or a combination of hardware device and software module.

Conventional devices and methods for generating an output frequency input control voltages to a VCO that vary according to temperature (e.g., the temperature of the VCO) in order to compensate for temperature-induced frequency drift of the VCO. However, this approach is insufficiently effective for use in wide-band PLLs, particularly in instances in which a desired frequency falls within a lower frequency band of the VCO. Accordingly, the conventional devices and methods are unable to sufficiently prevent or reduce the temperature-induced frequency drift of the VCO resulting in excessive interference in adjacent frequency bands and/or reduction in communication signal quality (e.g., due to interference with adjacent bands, etc.).

However, according to embodiments, improved devices and methods are provided for generating an output frequency. For example, the improved devices and methods cause a temperature-varying current to be provided to the VCO that corrects for and/or reduces the temperature-induced frequency drift of the VCO. Accordingly, the improved devices and methods overcome the deficiencies of the conventional devices and methods to at least reduce interference in adjacent frequency bands and/or improve communication signal quality.

According to embodiments, operations described herein as being performed by the controller, the processor, circuit 200, the V2I converter 202, the IDAC 204, the CCO 206, the Vctrl 208, the VCO 210 and/or the BMR 212 may be performed by processing circuitry. The term 'processing circuitry,' as used in the present disclosure, may refer to, for example, hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

The various operations of methods described above may be performed by any suitable device capable of performing the operations, such as the processing circuitry discussed above. For example, as discussed above, the operations of methods described above may be performed by various hardware and/or software implemented in some form of hardware (e.g., processor, ASIC, etc.).

The software may comprise an ordered listing of executable instructions for implementing logical functions, and may be embodied in any "processor-readable medium" for use by or in connection with an instruction execution system, apparatus, or device, such as a single or multiple-core processor or processor-containing system.

The blocks or operations of a method or algorithm and functions described in connection with embodiments disclosed herein may be embodied directly in hardware, in a software module executed by a processor, or in a combination of the two. If implemented in software, the functions may be stored on or transmitted over as one or more instructions or code on a tangible, non-transitory computer-readable medium. A software module may reside in Random Access Memory (RAM), flash memory, Read Only Memory (ROM), Electrically Programmable ROM (EPROM), Electrically Erasable Programmable ROM (EEPROM), registers, hard disk, a removable disk, a CD ROM, or any other form of storage medium known in the art.

It will be understood that when an element is referred to as being "connected" or "coupled" to another element, it may be directly connected or coupled to the other element or intervening elements may be present. As used herein the term "and/or" includes any and all combinations of one or more of the associated listed items.

The foregoing description of the specific examples will so fully reveal the general nature of embodiments herein that others may, by applying current knowledge, readily modify and/or adapt for various applications such specific examples without departing from the scope of the invention as defined by the appended claims.

## Claims

1. A circuit for reducing a temperature-induced frequency drift in a voltage to current, V2I, converter (202) based voltage-controlled oscillator (210), VCO, for at least one wide band phase-locked loop, PLL, the circuit having said VCO comprising said V2I converter (202) and a current controlled oscillator (206), CCO, the circuit comprising:
a V2I resistor node of the V2I converter, the V2I resistor node being at one end of a resistor (R), wherein the V2I converter includes an amplifier configured to have negative feedback to maintain a resistor current through the resistor, and the resistor configured to have current proportional to an input voltage for controlling the circuit, and wherein the resistor has a negligible temperature co-efficient with negative feedback of the amplifier of the V2I converter, the resistor configured to provide current through the V2I resistor node having a value that is constant with absolute temperature, ZTAT,
wherein the circuit is configured to:
provide a fixed offset current (IPTAT) to the V2I resistor node to cause at least one V2I output current to have a value conversely proportional to absolute temperature, CTAT, the at least one V2I output current (IV2I) being output by the V2I converter (202);
mirror the at least one V2I output current (IV2I) to the CCO (206) to reduce the temperature-induced frequency drift at a lower frequency band of the VCO (210); and
provide the fixed offset current having a value that is proportional to absolute temperature, PTAT, and induces an opposite of the temperature-induced frequency drift in a current of the CCO (206).

2. The circuit as claimed in claim 1, wherein the circuit is configured to provide the fixed offset current (IPTAT) having a value that is PTAT by increasing a voltage to frequency gain of the VCO (210).

3. The circuit as claimed in any preceding claim, wherein
the fixed offset current (IPTAT) has a value that is PTAT and is generated by a PTAT branch of the circuit; and
the circuit is configured to selectively turn on the PTAT branch based on the VCO (210) being configured to oscillate at the lower frequency band without affecting loop dynamics of the at least one wide band PLL.

4. A method for reducing a temperature-induced frequency drift in a voltage to current, V2I, converter (202) based voltage-controlled oscillator, VCO, (210) for at least one wide band phase-locked loop, PLL, the VCO comprising said V2I converter and a current controlled oscillator (206), CCO, the V2I converter (202) including a V2I resistor node at one end of a resistor and an amplifier, the V2I converter (202) being connected to a current controlled oscillator (206), CCO, and the method comprising:
providing, via the resistor, current through the V2I resistor node having a value that is constant with absolute temperature, by maintaining, through the resistor and using the negative feedback of the amplifier, a current that is proportional to an input voltage for controlling the circuit, where in the resistor has a negligible temperature co-efficient with negative feedback of the amplifier of the V2I converter;
providing a fixed offset current to the V2I resistor node to cause at least one V2I output current to have a value conversely proportional to absolute temperature, CTAT, the at least one V2I output current being output by the V2I converter (202), wherein the fixed offset current has a value that is proportional to absolute temperature, to thereby induce an opposite of the temperature-induced frequency drift in a current of the CCO (206); and
mirroring the at least one V2I output current to the CCO (206) to reduce the temperature-induced frequency drift at a lower frequency band of the VCO (210).

## Patentansprüche

1. Schaltung zur Verringerung einer temperaturinduzierten Frequenzdrift in einem spannungsgesteuerten Oszillator, VCO, (210), der auf einem Spannung-Strom-Wandler, V2I, (202) basiert, für mindestens eine breitbandige Phasenregelschleife, PLL, wobei die Schaltung, die den VCO aufweist, den Spannung-Strom-Wandler (202) und einen stromgesteuerten Oszillator (206), CCO, umfasst, wobei die Schaltung umfasst:
einen V2I-Widerstandsknoten des V2I-Wandlers, wobei der V2I-Widerstandsknoten sich an einem Ende eines Widerstands (R) befindet, wobei der V2I-Wandler einen Verstärker einschließt, der dafür konfiguriert ist, eine negative Rückkopplung aufzuweisen, um einen Widerstandsstrom durch den Widerstand beizubehalten, und der Widerstand dafür konfiguriert ist, einen Strom aufzuweisen, der proportional zu einer Eingangsspannung zum Steuern der Schaltung ist, und wobei der Widerstand mit negativer Rückkopplung des Verstärkers des V2I-Wandlers einen vernachlässigbaren Temperaturkoeffizienten aufweist, wobei der Widerstand dafür konfiguriert ist, Strom durch den V2I-Widerstandsknoten bereitzustellen, der einen Wert aufweist, der bei der absoluten Temperatur, ZTAT, konstant ist,
wobei die Schaltung dafür konfiguriert ist:
einen festen Offset-Strom (IPTAT) für den V2I-Widerstandsknoten bereitzustellen, um zu bewirken, dass mindestens ein V2I-Ausgangsstrom einen Wert aufweist, der umgekehrt proportional zur absoluten Temperatur, CTAT, ist, wobei der mindestens eine V2I-Ausgangsstrom (IV2I) durch den V2I-Wandler (202) ausgegeben wird;
den mindestens einen V2I-Ausgangsstrom (IV2I) zum CCO (206) zu spiegeln, um die temperaturinduzierte Frequenzdrift in einem unteren Frequenzband des VCO (210) zu verringern; und
den festen Offset-Strom bereitzustellen, der einen Wert aufweist, welcher proportional zur absoluten Temperatur, PTAT, ist und in einem Strom des CCO (206) eine der temperaturinduzierten Frequenzdrift entgegengesetzte Drift induziert.

2. Schaltung nach Anspruch 1, wobei die Schaltung dafür konfiguriert ist, den festen Offset-Strom (IPTAT), der einen Wert aufweist, welcher PTAT ist, durch Erhöhung einer Spannungs-Frequenz-Verstärkung des VCO (210) bereitzustellen.

3. Schaltung nach einem vorstehenden Anspruch, wobei:
der feste Offset-Strom (IPTAT) einen Wert aufweist, der PTAT ist, und durch einen PTAT-Zweig der Schaltung erzeugt wird; und
die Schaltung dafür konfiguriert ist, den PTAT-Zweig selektiv einzuschalten, und zwar darauf beruhend, dass der VCO (210) dafür konfiguriert ist, im unteren Frequenzband zu oszillieren, ohne die Schleifendynamik der mindestens einen Breitband-PLL zu beeinträchtigen.

4. Verfahren zur Verringerung einer temperaturinduzierten Frequenzdrift in einem spannungsgesteuerten Oszillator, VCO, (210), der auf einem Spannung-Strom-Wandler, V2I, (202) basiert, für mindestens eine breitbandige Phasenregelschleife, PLL, wobei der VCO den V2I-Wandler und einen stromgesteuerten Oszillator (206), CCO, umfasst, wobei der V2I-Wandler (202) einen V2I-Widerstandsknoten an einem Ende eines Widerstands und einen Verstärker einschließt, wobei der V2I-Wandler (202) mit einem stromgesteuerten Oszillator (206), CCO, verbunden ist, und wobei das Verfahren umfasst:
Bereitstellen eines Stroms über den Widerstand durch den V2I-Widerstandsknoten, der einen Wert aufweist, welcher mit der absoluten Temperatur konstant ist, indem durch den Widerstand und unter Verwendung der negativen Rückkopplung des Verstärkers ein Strom beibehalten wird, der proportional zu einer Eingangsspannung zum Steuern der Schaltung ist, wobei der Widerstand bei negativer Rückkopplung des Verstärkers des V2I-Wandlers einen vernachlässigbaren Temperaturkoeffizienten aufweist;
Bereitstellen eines festen Offset-Stroms für den V2I-Widerstandsknoten, um zu bewirken, dass mindestens ein V2I-Ausgangsstrom einen Wert aufweist, der umgekehrt proportional zur absoluten Temperatur, CTAT, ist, wobei der mindestens eine V2I-Ausgangsstrom durch den V2I-Wandler (202) ausgegeben wird, wobei der feste Offset-Strom einen Wert aufweist, der proportional zur absoluten Temperatur ist, um dadurch in einem Strom des CCO (206) eine der temperaturinduzierten Frequenzdrift entgegengesetzte Drift zu induzieren; und
Spiegeln des mindestens einen V2I-Ausgangsstroms zum CCO (206), um die temperaturinduzierte Frequenzdrift in einem unteren Frequenzband des VCO (210) zu verringern.

## Revendications

1. Circuit de réduction d'une dérive en fréquence induite par la température dans un oscillateur commandé en tension, VCO, (210) sur la base d'un convertisseur de tension en courant, V2I, (202), destiné à au moins une boucle à verrouillage de phase, PLL, à bande large, le circuit comportant ledit VCO comprenant ledit convertisseur V2I (202) et un oscillateur commandé en courant, CCO, (206), le circuit comprenant :
un nœud de résistance V2I du convertisseur V2I, le nœud de résistance V2I étant situé à une extrémité d'une résistance (R), dans lequel le convertisseur V2I inclut un amplificateur configuré pour présenter un retour négatif de façon à maintenir un courant de résistance à travers la résistance, et la résistance configurée pour présenter un courant proportionnel à une tension d'entrée permettant de commander le circuit, et dans lequel la résistance présente un coefficient de température négligeable avec un retour négatif de l'amplificateur du convertisseur V2I, la résistance configurée pour délivrer un courant par l'intermédiaire du nœud de résistance V2I ayant une valeur qui est constante par rapport à une température absolue, ZTAT,
dans lequel le circuit est configuré pour :
délivrer un courant de décalage fixe (IPTAT) au nœud de résistance V2I de façon à amener au moins un courant de sortie V2I à présenter une valeur inversement proportionnelle à une température absolue, CTAT, le au moins un courant de sortie V2I (IV2I) étant délivré en sortie par le convertisseur V2I (202) ;
reproduire en miroir le au moins un courant de sortie V2I (IV2I) sur le CCO (206) de façon à réduire la dérive en fréquence induite par la température au niveau d'une bande de fréquences inférieure du VCO (210) ; et
délivrer le courant de décalage fixe ayant une valeur qui est proportionnelle à une température absolue, PTAT, et qui induit un opposé de la dérive en fréquence induite par la température dans un courant du CCO (206).

2. Circuit selon la revendication 1, dans lequel le circuit est configuré pour délivrer le courant de décalage fixe (IPTAT) présentant une valeur qui est PTAT en augmentant un gain de tension en fréquence du VCO (210).

3. Circuit selon une quelconque revendication précédente, dans lequel
le courant de décalage fixe (IPTAT) présente une valeur qui est PTAT et qui est générée par une branche PTAT du circuit ; et
le circuit est configuré pour activer sélectivement la branche PTAT sur la base du VCO (210) configuré pour osciller au niveau de la bande de fréquences inférieure sans affecter la dynamique de boucle de la au moins une PLL à bande large.

4. Procédé de réduction d'une dérive en fréquence induite par la température dans un oscillateur commandé en tension, VCO, (210) sur la base d'un convertisseur de tension en courant, V2I, (202) destiné à au moins une boucle à verrouillage de phase, PLL, à bande large, le VCO comprenant ledit convertisseur V2I et un oscillateur commandé en courant, CCO, (206), le convertisseur V2I (202) incluant un nœud de résistance V2I à une extrémité d'une résistance et d'un amplificateur, le convertisseur V2I (202) étant raccordé à un oscillateur commandé en courant, CCO, (206), et le procédé comprenant les étapes consistant à :
délivrer, par l'intermédiaire de la résistance, un courant à travers le nœud de résistance V2I ayant une valeur qui est constante par rapport à une température absolue, en maintenant, à travers la résistance et au moyen du retour négatif de l'amplificateur, un courant qui est proportionnel à une tension d'entrée permettant de commander le circuit, dans lequel la résistance présente un coefficient de température négligeable par rapport à un retour négatif de l'amplificateur du convertisseur V2I ;
délivrer un courant de décalage fixe au nœud de résistance V2I de façon à amener au moins un courant de sortie V2I à avoir une valeur inversement proportionnelle à une température absolue, CTAT, le au moins un courant de sortie V2I étant délivré en sortie par le convertisseur V2I (202), dans lequel le courant de décalage fixe présente une valeur qui est proportionnelle à une température absolue, de façon à induire ainsi un opposé de la dérive en fréquence induite par la température dans un courant du CCO (206) ; et
reproduire en miroir le au moins un courant de sortie V2I sur le CCO (206) de façon à réduire la dérive en fréquence induite par la température au niveau d'une bande de fréquences inférieure du VCO (210).
